# NEUE EUROPÄISCHE PATENTSCHRIFT

(11) **EP 1 268 872 B2**
(45) Veröffentlichungstag und Bekanntmachung des Hinweises auf die Entscheidung über den Einspruch: **20.01.2010**
(45) Hinweis auf die Patenterteilung: 10.09.2003
(21) Anmeldenummer: 01938052.6
(22) Anmeldetag: 27.03.2001
(51) Int. Cl.: C23C 14/00

(54) **VERFAHREN ZUR REGELUNG VON REAKTIVEN SPUTTERPROZESSEN**
METHOD FOR CONTROLLING REACTIVE SPUTTERING PROCESSES
PROCEDE POUR REGULER DES PROCESSUS DE PULVERISATION CATHODIQUE REACTIVE

(30) Priorität: 27.03.2000 DE 10015150
(43) Veröffentlichungstag der Anmeldung: 02.01.2003
(73) Patentinhaber: Fraunhofer-Gesellschaft zur Förderung der angewandten Forschung e.V., 80686 München (DE)
(72) Erfinder: BRINGMANN, Udo, 25469 Halstenbek (DE); HÖING, Thomas, 38106 Braunschweig (DE); MALKOMES, Niels, 38106 Braunschweig (DE); SZYSZKA, Bernd, 38108 Braunschweig (DE); VERGÖHL, Michael, 38162 Destedt (DE); PÖCKELMANN, Ralf, 21073 Hamburg (DE)
(74) Vertreter: Pfenning, Meinig & Partner GbR
(86) Internationale Anmeldenummer: PCT/EP2001/003443
(87) Internationale Veröffentlichungsnummer: WO 2001/073151

(56) Entgegenhaltungen:
- EP-A- 0 795 623
- US-A- 4 428 811
- US-A- 4 975 168
- US-A- 5 040 559
- US-A- 5 423 970
- "PRECISION INSTRUMENTS LEAVE LAB, ENTER PROCESS AREAS" MACHINE DESIGN, PENTON,INC. CLEVELAND, US, Bd. 61, Nr. 4, 23. Februar 1989 (1989-02-23), Seite 66 XP000052320 ISSN: 0024-9114
- CHU X ET AL: "REACTIVE MAGNETRON SPUTTER DEPOSITION OF POLYCRYSTALLINE VANADIUM NITRIDE FILMS" JOURNAL OF VACUUM SCIENCE AND TECHNOLOGY: PART A, AMERICAN INSTITUTE OF PHYSICS. NEW YORK, US, Bd. 14, Nr. 6, 1. November 1996 (1996-11-01), Seiten 3124-3129, XP000638667 ISSN: 0734-2101
- HMIEL A F: "PARTIAL PRESSURE CONTROL OF REACTIVELY SPUTTERED TITANIUM NITRIDE" JOURNAL OF VACUUM SCIENCE AND TECHNOLOGY: PART A, AMERICAN INSTITUTE OF PHYSICS. NEW YORK, US, Bd. 3, Nr. 3, 1. Mai 1985 (1985-05-01), Seiten 592-595, XP002007091 ISSN: 0734-2101
- MKS INSTRUMENTS: 'Datenblatt MKS-Massenflusscontroller Typ 1179, Bulletin 1179A-6102' 2002,

## Beschreibung

Die vorliegende Erfindung bezieht sich auf ein Verfahren zur Regelung von DC-, MF- oder HF-angeregten reaktiven Sputterprozessen. Plasmasputtern ist eine etablierte Technologie für die Beschichtung von Substraten, insbesondere mit keramischen oder anderen mehrkomponentigen Funktionsschichten. Das Sputtern, insbesondere das reaktive Magnetronsputtern basiert auf dem Sputtern von metallischen Targets in einer reaktiven Atmosphäre mit dem Ziel, auf dem Substrat die gewünschte Verbindung mit der gewünschten Mikrostruktur und Phasenzusammensetzung bei hoher Rate aufwachsen zu lassen.

Ein wesentliches Problem resultiert jedoch daraus, daß der Reaktivgas-Partialdruck in konventionellen Sputterprozessen nicht stetig verändert werden kann. Der Parameterraum zerfällt daher in die definierten Bereiche "Compound Mode" mit hohem Reaktivgas-Partialdruck und einer vollständig mit Reaktionsprodukten bedeckten Targetoberfläche sowie stöchiometrischen Schichten am Substrat und einem "Metallic Mode" mit einem geringen Reaktivgas-Partialdruck in der Sputterkammer, einer weitgehend metallischen Targetoberfläche und dem Aufwachsen von metallischen Schichten auf dem Substrat. Zwischen diesen Bereichen ist im allgemeinen kein stetiger Übergang möglich, es resultieren vielmehr instabile Prozeßzustände, deren Zustandekommen im folgenden skizziert wird. Dabei wird beispielhaft auf das Reaktivgas O₂ Bezug genommen, die angeführten Mechanismen gelten jedoch auch für Sputtern in N₂, CHₓ, und dgl.

Zu Beginn des Magnetronsputterns wird Reaktivgas in die Sputterkammer zugegeben. Daraufhin laufen auf der Targetoberfläche konkurrierende Wachstums- und Ätzprozesse ab. Bei niedrigem O₂-Partialdruck ist die Rate für das Aufwachsen der Oxidbedeckung gering, so daß der Ätzprozeß durch den Sputterabtrag der Oxidschicht überwiegt. Die Targetoberfläche bleibt daher insgesamt metallisch. Dieser Zustand ist stabil, da das Target als effiziente Getterpumpe arbeitet, deren effektives Saugvermögen oftmals ein Vielfaches des Saugvermögens der eigentlich zur Evakuierung eingesetzten Turbopumpe beträgt.

Wird der Reaktivgas-Partialdruck erhöht, so wächst auf der Targetoberfläche eine Oxidschicht mit etwas höherer Rate auf. Bei geringen Ionenstromdichten und somit geringer Ätzrate überwiegt dann der Wachstumsprozeß. Auf diese Weise entstehen mit Reaktionsprodukten bedeckte Targetbereiche, die auch als "vergiftete Targetbereiche" bezeichnet werden.

Diese vergifteten Targetbereiche weisen gegenüber dem Metall stets eine geringere Sputterausbeute auf, so daß insgesamt weniger Targetmaterial gesputtert wird. Dies führt zu einer Abnahme des Materialabtrags am Target, einer Verminderung des Targetsaugvermögens und damit zu einer weiteren Erhöhung des Reaktivgas-Partialdrucks.

Sobald der Reaktivgas-Partialdruck einen kritischen Wert überschreitet, kommt es folglich zu einem selbstverstärkenden Effekt, da die Erhöhung des Reaktivgas-Partialdrucks eine Verminderung des Saugvermögens der Target-Getterpumpe zur Folge hat, woraus wiederum eine Erhöhung des Reaktivgas-Partialdrucks resultiert. Diese Instabilität kennzeichnet den Übergang vom Metallic Mode in den Compound Mode.

Technisch von großem Interesse ist nun gerade die Stabilisierung des unstetigen Übergangs zwischen diesen beiden Zuständen, da zum einen die Wachstumsrate im Compound Mode bedingt durch die niedrige Sputterausbeute nur gering ist, andererseits die Schichten im Compound Mode unter Reaktivgasüberschuß aufwachsen, woraus ungünstige Schichteigenschaften resultieren. Andererseits ist der Reaktivgas-Partialdruck im Metallic Mode im allgemeinen zu gering, so daß dann absorbierende unterstöchiometrische Verbindungen aufwachsen.

Die gewünschter stöchiometrischen Schichten können jedoch dann bei hoher Rate abgeschieden werden, wenn der Prozeß genau im instabilen Übergangsbereich, der auch als "Transition Mode" bezeichnet wird, betrieben wird. Die Stabilisierung dieses unstetigen Übergangszustandes "Transition Mode" ist durch Regelkreise möglich, die das dynamische Verhalten der Quellen berücksichtigen und die so die technisch interessanten instabilen Arbeitspunkte aufrechterhalten können.

Aus der Literatur sind verschiedene Ansätze zur Lösung der oben genannten Aufgabenstellung bekannt. Technisch etabliert ist vor allem die Regelung des Reaktivgasflusses nach Maßgabe der optischen Plasmaemission ausgewählter Spektrallinien, wie sie in der Dissertation von von J. Strümpfel, "Prozeßstabilisierung beim reaktiven Hochratenzerstäuben mittels optischer Emissionsspektroskopie zur industriellen Herstellung von Indium-Zinn-Oxidschichten und Titandioxidschichten", Chemnitz, 1991 beschrieben ist. Dabei wird der Reaktivgasfluß über schnellschaltende Piezoventile vorgegeben. Derartige Regelkreise zeichnen sich durch ein sehr schnelles Ansprechverhalten aus, da die Messung der optischen Plasmaemission und die Ansteuerung der Piezoventile mit kleinen Zeitkonstanten im Millisekundenbereich erfolgt. Sie haben jedoch den wesentlichen Nachteil, daß ein sehr hoher Aufwand für die optische Meßtechnik zur Detektion der Intensität der gewünschten Spektrallinien erforderlich ist und damit eine industrielle Anwendung gewöhnlich nicht in Betracht kommt.

Ein weiteres Verfahren ist die Regelung reaktiver Prozesse zur Deposition oxidischer Schichten nach Maßgabe einer O₂-Partialdruckmessung mittels Lambda-Sonde durch die Anpassung der Entladungsleistung oder des Entladungsstromes. Ein entsprechendes Konzept ist aus der EP 0 795 623 A1 bekannt.

Derartige Regelkreise können im Hinblick auf den industriellen Einsatz deutlich robuster ausgelegt werden, da die aufwendige optische Meßtechnik zur Analyse der Plasmaemission entfällt. Speziell bei Großanlagen ist die Regelung der elektrischen Parameter jedoch mit erheblichen Anforderungen an die Leistungsversorgung verbunden, da sowohl ein hinreichend schnelles Ansprechverhalten als auch eine hinreichende Leistungsreserve zur Durchführung der Regelung vorgesehen werden muß.

Aufgabe der vorliegenden Erfindung ist es daher, ein Verfahren und eine Vorrichtung zur Regelung von DC-, MF- oder HF-angeregten reaktiven Sputterprozessen zur Verfügung zu stellen, das mit geringeren'technischem Aufwand eine ausreichende Stabilisierung des Sputterprozesses im Übergangsbereich ermöglicht.

Diese Aufgabe wird durch das Verfahren gemäß Patentanspruch 1 und die Vorrichtung nach Patentanspruch 4 gelöst. Vorteilhafte Weiterbildungen des erfindungsgemäßen Verfahrens bzw. der erfindungsgemäßen Vorrichtung werden in den jeweiligen abhängigen Ansprüchen gegeben.

Erfindungsgemäß wird der Reaktivgas-Partialdruck in der Sputterkammer mit einer Lambda-Sonde gemessen und basierend auf diesen Meßergebnissen der Reaktivgasfluß mit einem konventionellen Massenflußregler geregelt. Eine derartige Regelung schien bisher nicht möglich, da konventionelle Massenflußregler in Verbindung mit einer Lambda-Sonde im Vergleich zu den aufwendigen aus dem Stand der Technik bekannten Piezosystemen eine um mehrere Größenordnungen höhere Ansprechzeit aufweisen. Es war daher zu erwarten, daß mit einer Kombination aus Lambda-Sonde und Regelung des Reaktivgasflusses keine Stabilisierung des Übergangszustandes beim reaktiven Sputtern möglich sein würde.

Überraschenderweise wurde jedoch von den Erfindern der vorliegenden Erfindung festgestellt, daß neben der oben beschriebenen bekannten Leistungsregelung in Verbindung mit einer Lambda-Sonde auch ein konventioneller Massenfluß-Controller zur Regelung des Reaktivgasflusses eingesetzt werden kann, wenn die Parameter der PID-Regelung günstig ausgelegt werden. Es stellte sich dabei überraschenderweise heraus, daß die Ansprechzeiten der Massenflußregler bei guter Auslegung des Reglers nicht den begrenzenden Faktor für die Regelung darstellen und daher überraschenderweise auch Massenflußregler in Verbindung mit Lambda-Sonden zur Regelung von reaktiven Sputterprozessen geeignet sind.

Dies hat u.a. die Vorteile, daß konventionelle Massenflußregler, wie z.B. die Modelle der Baureihen 1259 und 1179 der Fa. MKS, Six Shattuck Road, Andover, MA 01810, USA kostengünstig und unaufwendig sind, so daß gerade für industrielle Großanlagen auf eine überdimensionierte Leistungsversorgung verzichtet werden kann, da die Zeitkonstanten der Leistungsversorgung bei Sollwert-Änderungen unkritisch sind.

Die Funktionsweise eines derartigen Massenfluß-Reglers beruht darauf, daß (i) der zu messende Gasfluß mit Temperaturänderungen entlang eines Laminaren-Gasfluß-Sensors korreliert und (ii) der so berechnete Gasfluß mit einem Regelventil geregelt wird.

Die Meßeinheit eines solchen Massenfluß-Reglers zur Bestimmung des Gasflusses ist als Temperaturmesselement in einem Sensorkanal ausgelegt, durch den nur eine Teilmenge des Gases strömt, während der Hauptanteil den größer dimensionierten Bypass-Kanal passiert. Zur Messung des Gasstroms wird das Temperaturmesselement mit mehreren Meßstellen elektrisch so aufgeheizt, daß eine konstante Temperatur entlang des Temperaturmesselements erreicht wird. Die aufzuwendende elektrische Leistung stellt dann ein Maß für den durch den Massenfluß-Regler hindurch fließenden Gasfluß dar.

Das erfindungsgemäße Verfahren und die erfindungsgemäße Vorrichtung eignen sich zur Regelung von Gleichstrom-(DC)-, Mittelfrequenz-(MF)-oder Hochfrequenz (HF)-Sputterprozessen.

Selbstverständlich kann neben dem Reaktivgasfluß über konventionelle Massenflußregler auch noch zusätzlich die DC-, MF- bzw. HF-Entladungsleistung geregelt werden, so daß eine noch bessere Konstanthaltung des Arbeitspunktes im Übergangsmodus gewährleistet wird.

Im folgenden wird ein Beispiel eines erfindungsgemäßen Verfahrens, das mit einer erfindungsgemäßen Vorrichtung durchgeführt wird, beschrieben. Es zeigen
- Fig. 1: eine MF-Sputterquelle;
- Fig. 2: die dynamische Simulation des reaktiven Sputterprozesses im Larson-Modell; und
- Fig. 3: experimentelle Daten zu den Hysteresekurven für ungeregelten Betrieb und zur Flußregelung nach Maßgabe einer Partialdruckmessung mittels Lambda-Sonde.

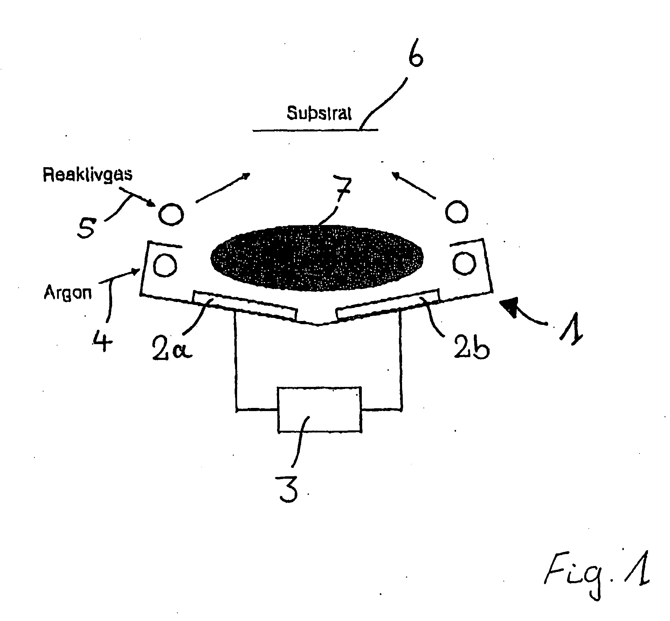

In dem beschriebenen Beispiel wurde das reaktive MF-Magnetronsputtern von Nb₂O₅-Schichtsystemen untersucht. In Fig. 1 ist die verwendete Sputteranlage 1 dargestellt. Diese enthält eine Doppelkathodenanordnung mit zwei konventionellen Magnetron-Kathoden 2a, 2b mit einem Targetformat von jeweils 488 x 88 mm². Das Sputtergas und das Reaktivgas werden über unabhängige Gasverteiler, die mit den Bezugszeichen 4 und 5 bezeichneten Pfeilen symbolisiert sind, getrennt über konventionelle Massenflußregler der Firma MKS zugegeben. Als Massenflußregler wurde bei den vorliegenden Beispielen jeweils ein Massenflußregler der Baureihe 1259 des Herstellers MKS verwendet.

Die konventionelle Magnetron-Kathoden 2a und 2b werden von einem MF-Generator und Anpaßeinheit 3 mit Leistung versorgt. Zwischen den Kathoden 2a und 2b und dem Substrat 6 wird während des Magnetronsputterns eine Plasmawolke 7 aufgebaut.

Die Messung des Reaktivgas-Partialdrucks erfolgte mit einer Lambda-Sonde, der das Prozeßgas über eine spezielle Gaszufuhr zugeführt wird. Der Regelkreis wurde auf der Basis eines Proportional-Integral-Differential-Reglers (PID-Regler) implementiert. Die Auslegung des PID-Regelkreises zur Regelung des O₂-Flusses nach Maßgabe des O₂-Partialdruckes erfolgte in dem vorliegenden Beispiel aufgrund von Modellrechnungen zur Simulation der Targetbedeckung, die auch das dynamische Verhalten der Targetbedeckung berücksichtigte.

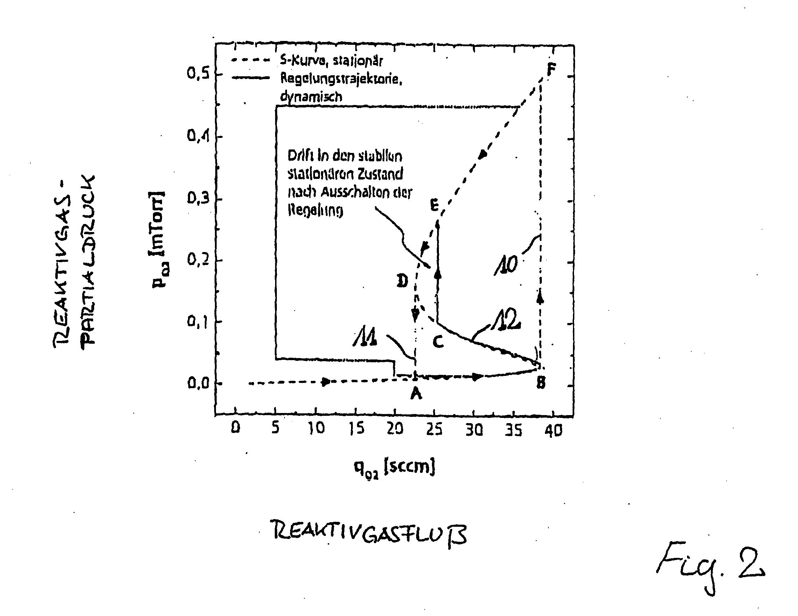

Fig. 2 zeigt ein typisches Beispiel für die Modellierung des reaktiven Sputterns gemäß diesem Ansatz. Aufgetragen ist hier der berechnete Reaktivgas-Partialdruck in Abhängigkeit des Reaktivgasflusses im Rahmen einer dynamischen Simulation des reaktiven Sputterprozesses im Larson-Modell. Für die Regelung wurde eine PID-Algorythmus eingesetzt, wobei die Modellparameter an die experimentellen Parameter angepaßt würden.

Der gestrichelte Kurvenverlauf ergibt die stationäre Lösung der Larson-Differentialgleichung an, die eine vereinfachte Beschreibung des Hystereseproblems beim reaktiven Sputtern ermöglichen. Entlang der gestrichelten S-Kurve werden bei Erhöhung des Reaktivgasflusses zunächst stabile Arbeitspunkte bis hin zum Punkt B erreicht (Metallic Mode, Metall-Mode).

Ohne eine Prozeßregelung würde bei weiterer Erhöhung des Reaktivgasflusses über den Punkt B hinaus eine abrupte Oxidation der gesamten Targetoberfläche erfolgen, was einen ebenfalls gestrichelt eingezeichneten abrupten unstetigen Übergang (Bezugszeichen 10) vom Arbeitspunkt B zum Arbeitspunkt F nach sich zieht. Im Arbeitspunkt F liegt der Compound Mode (reaktive Mode) vor. Wird nunmehr der O₂-Fluß wiederum abgesenkt, wird ein analoges Verhalten beim Übergang vom Punkt D zum Punkt A (Bezugszeichen 11) beobachtet, d.h. ein abrupter Übergang vom Compound Mode zum Metallic Mode. Demzufolge sind die instabilen Arbeitspunkte im Übergangsbereich (Transition Mode) zwischen den Punkten B und D (Bezugszeichen 12) ohne Prozeßregelung nicht für die Beschichtung zugänglich.

Die ausgezogene Kurve gibt nun den berechneten Verlauf des Reaktivgas-Partialdrucks wieder, wobei die Zeitabhängigkeit der Targetbedeckung in einfachen Modellen simuliert wurde. Für die ausgezogene Kurve wurde der Beschichtungsprozeß stabilisiert mittels eines PID-Reglers, dessen Parameter an das experimentelle Modell optimal angepaßt wurden.

Wie zu erwarten, entspricht nun die berechnete Regelungstrajektorie im wesentlichen der stationären Lösung des Larson-Modells. Das Ausschalten der Regelung ist für den Punkt C simuliert. Es erfolgt hier, wie zu erwarten ist, wiederum ein abrupter Übergang in den stationären Zustand E im Compound Mode.

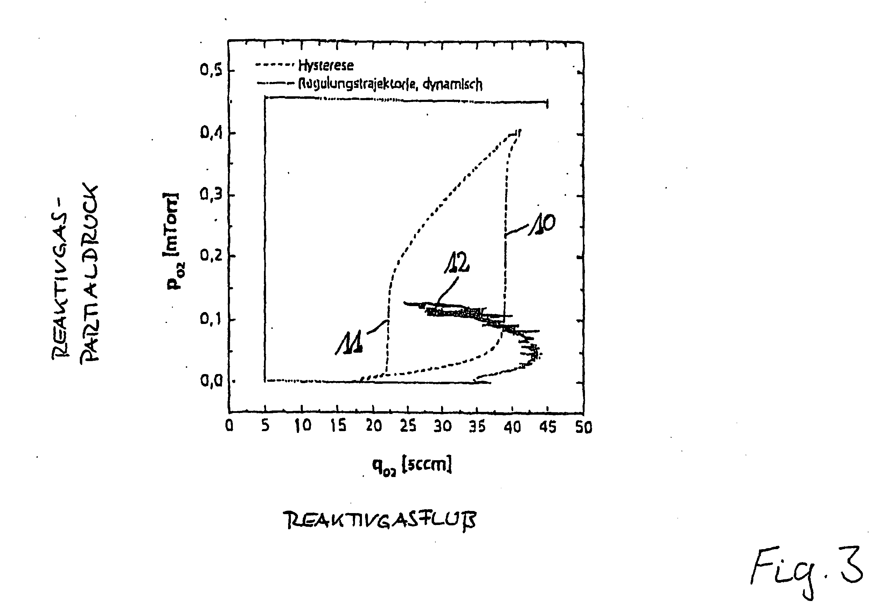

Fig. 3 zeigt die experimentell gewonnenen Ergebnisse der Regelungstrajektorie, wobei als Prozeßparameter ein Nb-Target, eine Entladungsleistung von 4 kW, ein Argonfluß von 60 sccm (2,7 x 10¹⁹ Atome/s) und einen Argondruck von 1,1 mTorr verwendet wurde. Für gleiche Kurvenelemente wurden dieselben Bezugszeichen wie in Fig. 2 verwendet.

Die Schlußregelung erfolgte nach Maßgabe der Partialdruckmessung mittels Lambda-Sonde.

Die Kurven 10 und 11 zeigen wiederum die simulierten Daten, die denjenigen in Fig. 2 entsprechen. Die Kurve 12 ist nun keine simulierte Kurve sondern eine experimentell gemessene Regelungstrajektorie. Es ist zu . erkennen, daß mittels der erfindungsgemäßen Regelung unter Verwendung einer Lambda-Sonde und eines konventionellen Massenflußregler tatsächlich die Stabilisierung des Sputterprozesses im Übergangsbereich (Transition Mode) möglich ist.

## Patentansprüche

1. Verfahren zur Regelung von DC-, MF- oder HF-angeregten reaktiven Sputterprozessen,
**dadurch gekennzeichnet, daß**
der Reaktivgaspartialdruck mit einer λ-Sonde gemessen wird und basierend auf diesen Meßergebnissen über eine Proportional-Integral-Differential-Regelung der Reaktivgasfluß mit einem konventionellen Massenflußregler, der gegenüber Piezosystemen eine um mehrere Größenordnungen höhere Ansprechzeit aufweist, derart geregelt wird, daß der reaktive Sputterprozess im Übergangsbereich betrieben wird.

2. Verfahren nach dem vorhergehenden Anspruch, **dadurch gekennzeichnet, daß** basierend auf den Meßergebnissen der λ-Sonde die DC-, MF- bzw. HF-Entladungsleistung geregelt wird.

3. Verfahren nach einem der vorhergehenden Ansprüche, **dadurch gekennzeichnet, daß** der Reaktivgasfluß und die Entladungsleistung derart geregelt wird, daß der reaktive Sputterprozess im Bereich instabiler Arbeitspunkte betrieben wird.

4. Vorrichtung (1) zum Durchführen von DC-, MF- oder HF-angeregten Sputterprozessen mit einer Sputterkammer und einer Kathode (2a, 2b), auf der das zu zerstäubende Target angeordnet ist, und einem Generator (3) zur Erzeugung einer DC-, MF- oder HF-Spannung an der Kathode (2a, 2b)
**gekennzeichnet durch**
eine λ-Sonde zur Bestimmung des Reaktivgaspartialdrucks in der Kammer sowie
einem Massenflußregler, der gegenüber Piezosystemen eine um mehrere Größenordnungen höhere Ansprechzeit aufweist, und einen Proportional-Integral-Differential-Regler zur Regelung des Reaktivgasflusses aufgrund des bestimmten Reaktivgaspartialdrucks.

## Claims

1. Method of controlling DC-, MF- or HF-excited reactive sputtering processes, **characterised in that** the partial reactive gas pressure is measured by means of a λ-probe and the reactive gas flux will, on the basis of these measuring results, be controlled, and that through a proportional-integral-differential control system, by means of a conventional mass flux controller, which, as compared to piezosystems, shows a response time higher by several orders of magnitude, such that the reactive sputtering process will be run in the transition region.

2. Method according to the preceding Claim, **characterised in that** the DC-, MF- resp HF-discharge performance is controlled on the basis of the measuring results of the λ-probe.

3. Method according to one of the preceding Claims, **characterised in that** the reactive gas flux and the discharge performance are (is) controlled such that the reactive sputtering process will be run in the region of instable operating points.

4. Apparatus (1) for carrying out DC-, MF- or HF-excited sputtering processes and comprising a sputtering chamber and a cathode (2a, 2b) on which the target to be sputtered is located and a generator (3) for generating a DC-, MF- or HF-voltage on the cathode (2a, 2b),
**characterised by**
a λ-probe for determining the partial reactive gas pressure in the chamber as well as
a mass flux controller, which, as compared to piezosystems, shows a response time higher by several orders of magnitude, and a proportional-integral-differential controller for controlling the reactive gas flux on the basis of the determined partial reactive gas pressure.

## Revendications

1. Procédé pour régler des processus de pulvérisation réactive, excités en courant continu, en moyenne fréquence ou en haute fréquence, **caractérisé en ce que** la pression partielle de gaz réactif est mesurée au moyen d'une sonde λ et le débit de gaz réactif est réglé sur la base de ces résultats de mesure, au moyen d'une régulation proportionnelle, intégrale et différentielle, à l'aide d'un régulateur de débit massique classique, qui possède, par rapport à des systèmes piézoélectriques, un temps de réponse de plusieurs ordres de grandeur, de telle sorte que le processus de pulvérisation réactive fonctionne dans la zone de transition.

2. Procédé selon la revendication précédente, **caractérisé en ce que** la puissance de décharge en courant continu, en moyenne fréquence ou en haute fréquence est réglée sur la base des résultats de mesure de la sonde λ.

3. Procédé selon l'une des revendications précédentes, **caractérisé en ce que** le débit de gaz réactif et la puissance de décharge sont réglés de telle sorte que le processus de pulvérisation réactive fonctionne dans la zone de points de fonctionnement instables.

4. Dispositif (1) pour la mise en oeuvre de procédés de pulvérisation à excitation en courant continu, en moyenne fréquence ou en haute fréquence, comportant une chambre de pulvérisation et une cathode (2a, 2b), sur laquelle est disposée la cible à pulvériser, et un générateur (3) pour produire une tension continue, une tension en moyenne fréquence ou une tension en haute fréquence au niveau de la cathode (2a, 2b),
**caractérisé par**:
une sonde λ servant à déterminer la pression partielle de gaz réactif dans la chambre, ainsi
qu'un régulateur de débit massique, qui possède un temps de réponse supérieur de plusieurs ordres de grandeur par rapport à des systèmes piézoélectriques, et un régulateur proportionnel, intégral et différentiel servant à régler le débit de gaz réactif sur la base de la pression partielle déterminée du gaz réactif.
